# EUROPEAN PATENT APPLICATION

(11) **EP 4 518 298 A1**
(43) Date of publication of application: **05.03.2025**
(21) Application number: 23839785.5
(22) Date of filing: 18.05.2023
(51) Int. Cl.: H04M 1/02, H05K 5/00, G06F 1/16

(54) **ELECTRONIC DEVICE INCLUDING STRUCTURE FOR REDUCING NOISE CAUSED BY MOTOR**

(30) Priority: 14.07.2022 KR 20220087171; 23.08.2022 KR 20220105278
(71) Applicant: Samsung Electronics Co., Ltd., Suwon-si, Gyeonggi-do 16677 (KR)
(72) Inventor: KANG, Hyunggwang, Suwon-si Gyeonggi-do 16677 (KR); LEE, Dongyeop, Suwon-si Gyeonggi-do 16677 (KR); YUN, Hyunsik, Suwon-si Gyeonggi-do 16677 (KR); JEONG, Hoyoung, Suwon-si Gyeonggi-do 16677 (KR); KWAK, Yongsuk, Suwon-si Gyeonggi-do 16677 (KR); PARK, Minseok, Suwon-si Gyeonggi-do 16677 (KR); PARK, Eungkyu, Suwon-si Gyeonggi-do 16677 (KR); YOU, Jin, Suwon-si Gyeonggi-do 16677 (KR); LEE, Soyoung, Suwon-si Gyeonggi-do 16677 (KR); IM, Changhoon, Suwon-si Gyeonggi-do 16677 (KR)
(74) Representative: HGF
(86) International application number: PCT/KR2023/006807
(87) International publication number: WO 2024/014691

(57) **Abstract**

An electronic device according to an embodiment includes: a first housing including a frame cover; a second housing coupled to the first housing to be slidable relative to the first housing; a flexible display which is disposed on one surface of the second housing, and slides into or out of the first housing by movement of the second housing; a motor disposed on the frame cover; a pinion gear coupled to the motor to be rotatable by the motor; a rack gear which is disposed on an inner surface of the second housing, opposite to the one surface of the second housing, and is engaged with the pinion gear to be movable according to rotation of the pinion gear; and a battery disposed on a seating surface of the frame cover spaced apart from the motor, and configured to supply power to the motor, wherein the frame cover includes a plurality of first through holes penetrating the seating surface that is in contact with the battery.

## Description

### [Technical Field]

The present disclosure relates to an electronic device including a structure for reducing noise caused by a motor.

### [Background Art]

In order for a user to easily carry an electronic device, the electronic device may be miniaturized. Despite miniaturization of the electronic device, there is an increasing need for the electronic device in which a size of a display for displaying contents may be changed so that the user may be provided with various contents through the electronic device. For example, the electronic device may include a flexible display in which the size of the display exposed to an outside of the electronic device may be changed.

### [Disclosure]

### [Technical Solution]

An electronic device according to an embodiment may include a first housing including a frame cover. The electronic device according to an embodiment may include a second housing slidably coupled to the first housing. The electronic device according to an embodiment may include a flexible display, disposed on a surface of the second housing, sliding into an inside of the first housing or out to an outside of the first housing by moving of the second housing. The electronic device according to an embodiment may include a motor disposed on the frame cover. The electronic device according to an embodiment may include a pinion gear coupled to the motor to be rotatable by the motor. The electronic device according to an embodiment may include a rack gear, disposed on an inner surface of the second housing opposite to the surface of the second housing, engaged with the pinion gear to be movable according to rotation of the pinion gear. The electronic device according to an embodiment may include a battery disposed on a seating surface of the frame cover spaced apart from the motor, configured to supply power to the motor. The frame cover according to an embodiment may include a plurality of first through holes penetrating the seating surface contacting the battery.

An electronic device according to an embodiment may include a first housing including a frame cover. The electronic device according to an embodiment may include a second housing slidably coupled to the first housing. The electronic device according to an embodiment may include a flexible display, including a display area disposed on a surface of the second housing and exposed to an outside of the electronic device, changeable to a first state in which the display area is having a first size or to a second state in which the display area is having a second size greater than the first size by moving of the second housing. The electronic device according to an embodiment may include a motor disposed on the frame cover. The electronic device according to an embodiment may include a pinion gear coupled to the motor to be rotatable by the motor. The electronic device according to an embodiment may include a rack gear, disposed on an inner surface of the second housing opposite to the surface of the second housing, engaged with the pinion gear to be movable according to rotation of the pinion gear. The electronic device according to an embodiment may include a battery, disposed on a seating surface of the frame cover spaced apart from the motor, configured to supply power to the motor. The frame cover according to an embodiment may include a plurality of first through holes penetrating the seating surface contacting the battery. The second housing according to an embodiment may include a cover region overlapping at least a portion of the seating surface in the first state, and a plurality of second through holes penetrating the cover region.

### [Description of the Drawings]

FIG. 1 is a block diagram of an electronic device in a network environment according to various embodiments.
FIG. 2A is a top plan view of an exemplary electronic device in a first state.
FIG. 2B is a bottom view of an exemplary electronic device in a first state.
FIG. 2C is a top plan view of an exemplary electronic device in a second state.
FIG. 2D is a bottom view of an exemplary electronic device in a second state.
FIG. 3A and FIG. 3B are exploded perspective views of an exemplary electronic device.
FIG. 4A is a cross-sectional view of an exemplary electronic device in a first state.
FIG. 4B is a cross-sectional view of an exemplary electronic device in a second state.
FIG. 5A is a top plan view of an exemplary electronic device in a first state.
FIG. 5B is a top plan view of an exemplary electronic device in a second state.
FIG. 6A is a top plan view of a frame cover of an exemplary electronic device.
FIG. 6B is a cross-sectional view illustrating an example of a frame cover of an exemplary electronic device cut along line C-C' of FIG. 6A.
FIG. 7 is a top plan view of a first housing of an exemplary electronic device.
FIG. 8 is a top plan view of a second housing of an exemplary electronic device.

### [Mode for Invention]

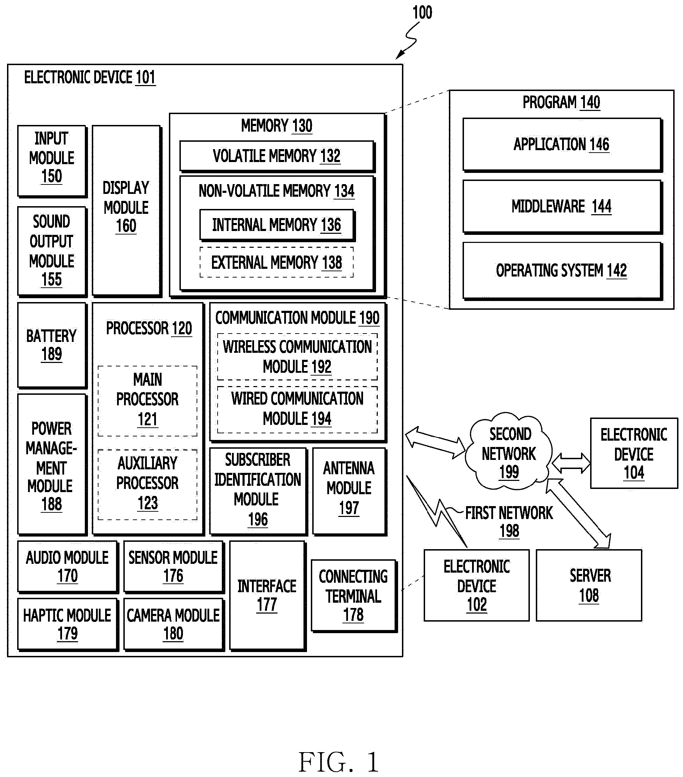

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

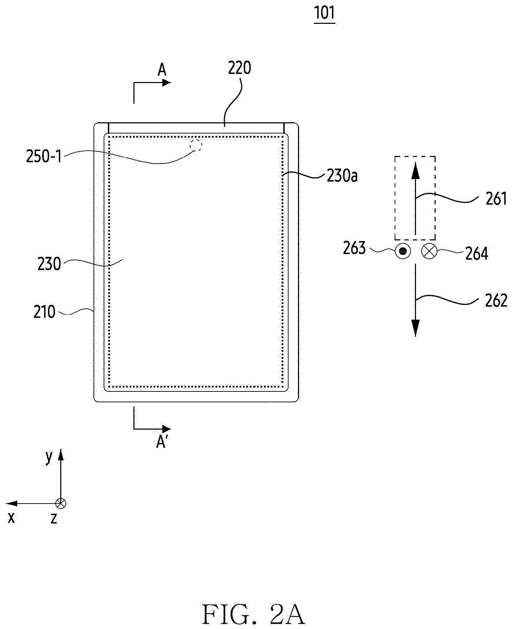

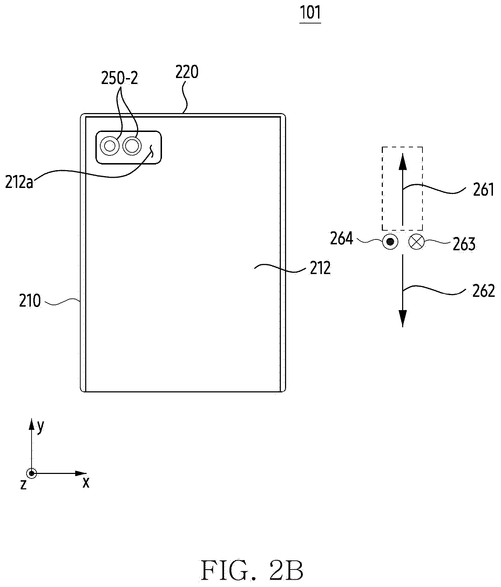

For example, a display of the display module 160 may be flexible. For example, the display may include a display area exposed outside a housing of the electronic device 101 that provides at least a portion of an outer surface of the electronic device 101. For example, since the display has flexibility, at least the portion of the display may be rollable into the housing or may be slidable into the housing. For example, a size of the display area may be changed according to the size of the at least the portion of the display rolled into the housing or slid into the housing. For example, the electronic device 101 including the display may be in a plurality of states including a first state providing the display area having a first size and a second state providing the display area having a second size different from the first size. For example, the first state may be exemplified through a description of FIG. 2A and FIG. 2B.

FIG. 2A is a top plan view of an exemplary electronic device 101 in a first state.

Referring to FIG. 2A, the electronic device 101 may include a first housing 210, a second housing 220 that is movable with respect to the first housing 210 in a first direction 261 parallel to the y-axis, or a second direction 262 parallel to the y-axis and opposite to the first direction 261, and a display 230 (e.g., the display).

For example, the electronic device 101 may be in the first state. For example, in the first state, the second housing 220 may be movable with respect to the first housing 210 in the first direction 261 of the first direction 261 and the second direction 262. For example, in the first state, the second housing 220 may not be movable in the second direction 262 with respect to the first housing 210.

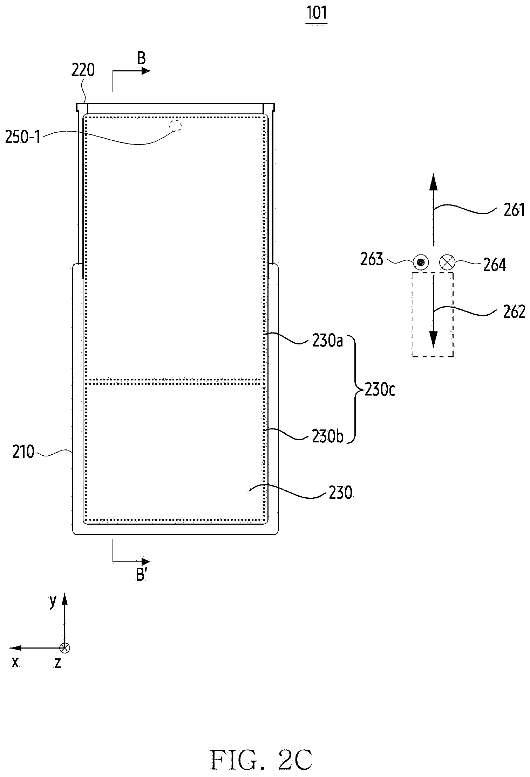

For example, in the first state, the display 230 may provide the display area having the smallest size. For example, in the first state, the display area may correspond to a region 230a. For example, although not illustrated in FIG. 2A, in the first state, the region (e.g., a region 230b of FIG. 2C) of the display 230 different from the region 230a that is the display area may be included in the first housing 210. For example, in the first state, the region may be covered by the first housing 210. For example, in the first state, the region may be rolled into the first housing 210. For example, in the first state, the region 230a may include a planar portion, unlike the region including a curved portion. However, it is not limited thereto. For example, the region 230a may also include the curved portion extended from the planar portion and positioned in an edge portion in the first state.

For example, the first state may be referred to as a slide-in state or a closed state in terms of at least a portion of the second housing 220 being positioned in the first housing 210. For example, the first state may be referred to as a reduced state in terms of providing the display area having the smallest size. However, it is not limited thereto.

For example, the first housing 210 may include a first image sensor 250-1 in a camera module 180 exposed through a portion of the region 230a and facing a third direction 263 parallel to the z-axis. For example, although not illustrated in FIG. 2A, the second housing 220 may include one or more second image sensors in the camera module 180 exposed through a portion of the second housing 220 and facing a fourth direction 264 parallel to the z-axis and opposite to the third direction 263. For example, the one or more second image sensors may be exemplified through a description of FIG. 2B.

FIG. 2B is a bottom view of an exemplary electronic device in a first state.

Referring to FIG. 2B, in the first state, one or more second image sensors 250-2 disposed in the second housing 220 may be positioned within a structure disposed in the first housing 210 for the one or more second image sensors 250-2. For example, light from an outside of the electronic device 101 may be received to the one or more second image sensors 250-2 through the structure in the first state. For example, since the one or more second image sensors 250-2 are positioned within the structure in the first state, the one or more second image sensors 250-2 may be exposed through the structure in the first state. For example, the structure may be implemented in various ways. For example, the structure may be an opening or a notch. For example, the structure may be an opening 212a in a plate 212 of the first housing 210 surrounding at least the portion of the second housing 220. However, it is not limited thereto. For example, in the first state, the one or more second image sensors 250-2 included in the second housing 220 may be covered by the plate 212 of the first housing 210.

Referring back to FIG. 1, the first state may be changed to the second state.

For example, the first state (or the second state) may be changed to the second state (or the first state) through one or more intermediate states between the first state and the second state.

For example, the first state (or the second state) may be changed to the second state (or the first state) based on a predefined user input. For example, the first state (or the second state) may be changed to the second state (or the first state) in response to a user input to a physical button exposed through the portion of the first housing 210 or the portion of the second housing 220. For example, the first state (or the second state) may be changed to the second state (or the first state) in response to the touch input to an executable object displayed in the display area. For example, the first state (or the second state) may be changed to the second state (or the first state) in response to the touch input having a contact point on the display area and having a pressing strength of more than a reference strength. For example, the first state (or the second state) may be changed to the second state (or the first state) in response to a voice input received through a microphone of the electronic device 101. For example, the first state (or the second state) may be changed to the second state (or the first state) in response to force applied to the first housing 210 and/or the second housing 220 to move the second housing 220 with respect to the first housing 210. For example, the first state (or the second state) may be changed to the second state (or the first state) in response to the user input identified on an external electronic device (e.g., earbuds or a smart watch) connected to the electronic device 101. However, it is not limited thereto.

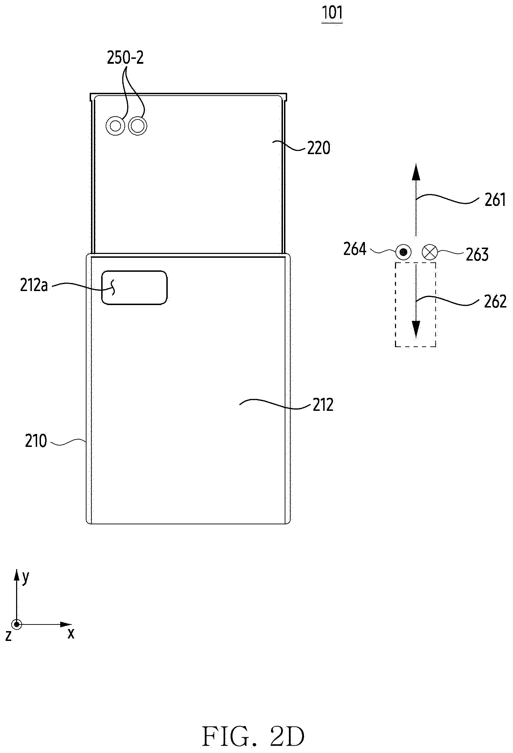

The second state may be exemplified through the description of FIG. 2C and FIG. 2D.

FIG. 2C is a top plan view of an exemplary electronic device in a second state.

Referring to FIG. 2C, the electronic device 101 may be in the second state. For example, in the second state, the second housing 220 may be movable with respect to the first housing 210 in the second direction 262 of the first direction 261 and the second direction 262. For example, in the second state, the second housing 220 may not be movable in the first direction 261 with respect to the first housing 210.

For example, in the second state, the display 230 may provide the display area having the largest size. For example, in the second state, the display area may correspond to a region 230c including the region 230a and the region 230b. For example, the region 230b included in the first housing 210 in the first state may be exposed in the second state. For example, in the second state, the region 230a may include the planar portion. However, it is not limited thereto. For example, the region 230a may also include the curved portion extended from the planar portion and positioned in the edge portion. For example, in the second state, the region 230b, unlike the region 230a in the first state, may include the planar portion of the planar portion and the curved portion. However, it is not limited thereto. For example, the region 230b may also include the curved portion extended from the planar portion of the region 230b and positioned in the edge portion.

For example, the second state may be referred to as a slide-out state or an open state in terms of at least the portion of the second housing 220 being positioned outside the first housing 210. For example, the second state may be referred to as an extended state in terms of providing the display area having the largest size. However, it is not limited thereto.

For example, when the state of the electronic device 101 changes from the first state to the second state, the first image sensor 250-1 facing the third direction 263 may move along with the region 230a according to movement of the second housing 220 in the first direction 261. For example, when the state of electronic device 101 changes from the first state to the second state, the one or more second image sensors 250-2 facing the fourth direction 264 although not illustrated in FIG. 2C may be moved according to the movement of the second housing 220 in the first direction 261. For example, a relative positional relationship between the one or more second image sensors 250-2 and the structure exemplified in the description of FIG. 2B may be changed according to the movement of the one or more second image sensors 250-2. For example, the change in the relative positional relationship may be exemplified through FIG. 2D.

FIG. 2D is a bottom view of an exemplary electronic device 101 in a second state.

Referring to FIG. 2D, in the second state, the one or more second image sensors 250-2 may be positioned outside the structure. For example, in the second state, the one or more second image sensors 250-2 may be positioned outside the opening 212a in the plate 212. For example, since the one or more second image sensors 250-2 are positioned outside the opening 212a in the second state, the one or more second image sensors 250-2 may be exposed in the second state. For example, since the one or more second image sensors 250-2 are positioned outside the structure in the second state, the relative positional relationship in the second state may be different from the relative positional relationship in the first state.

For example, in case that the electronic device 101 does not include the structure such as the opening 212a, the one or more second image sensors 250-2 in the second state may be exposed, unlike the one or more second image sensors 250-2 in the first state.

Although not illustrated in FIG. 2A, FIG. 2B, FIG. 2C, and FIG. 2D, the electronic device 101 may be in the intermediate state between the first state and the second state. For example, the size of the display area in the intermediate state may be larger than the size of the display area in the first state and smaller than the size of the display area in the second state. For example, the display area in the intermediate state may correspond to a region including the region 230a and a portion of the region 230b. For example, in the intermediate state, the portion of the region 230b may be exposed, and another portion (or a remaining portion) of the region 230b may be covered by the first housing 210 or rolled into the first housing 210. However, it is not limited thereto.

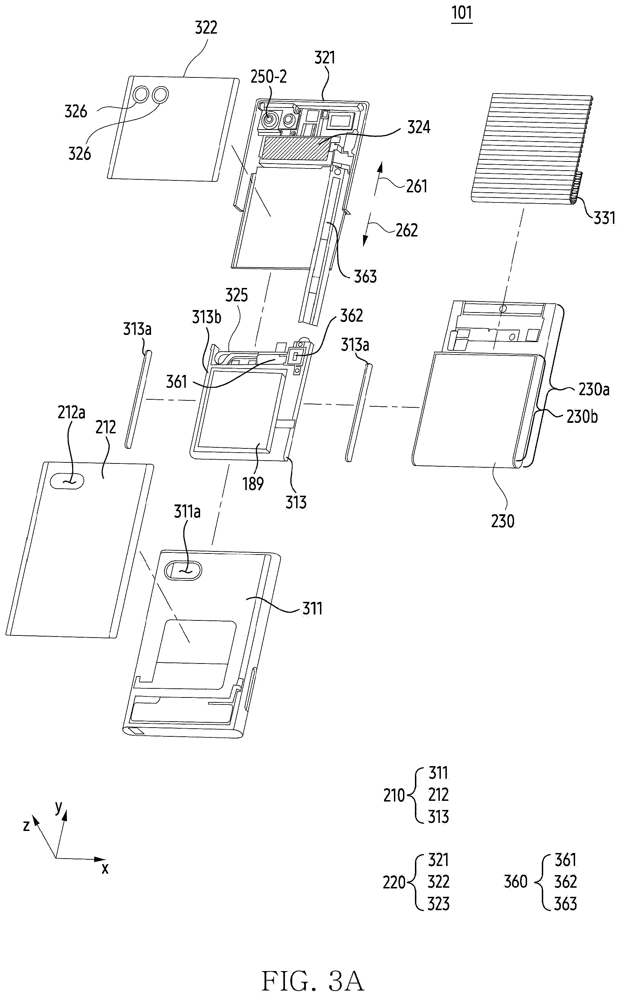

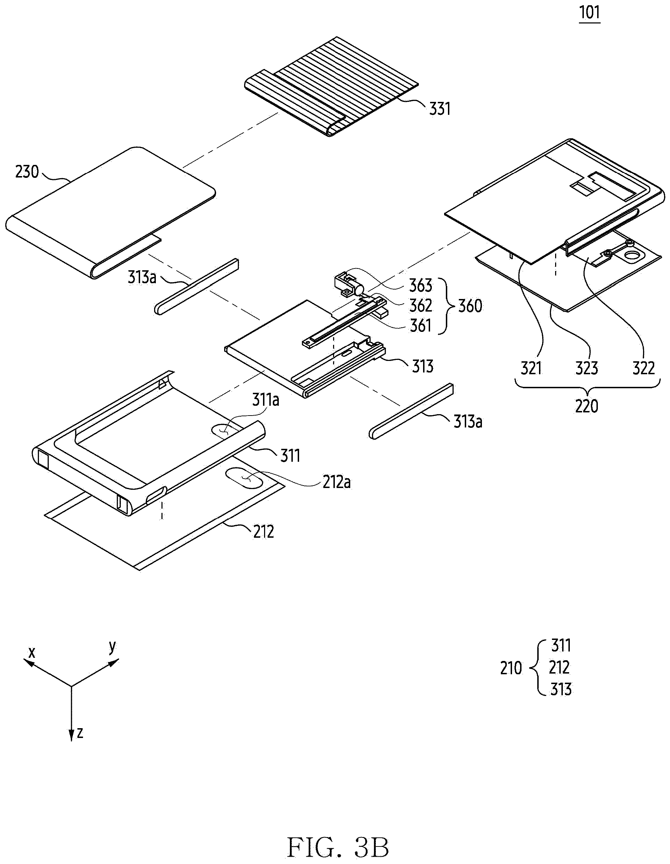

Referring back to FIG. 1, the electronic device 101 may include structures for moving the second housing (e.g., the second housing 220 of FIG. 2) of the electronic device 101 with respect to the first housing (e.g., the first housing 210 of FIG. 2) of the electronic device 101. For example, the structures may be exemplified through the description of FIG. 3A and FIG. 3B.

FIG. 3A and FIG. 3B are exploded perspective views of an exemplary electronic device.

Referring to FIG. 3A and FIG. 3B, an electronic device 101 may include a first housing 210, a second housing 220, a display 230, and a driving unit 360.

For example, the first housing 210 may include a book cover 311, a plate 212, and a frame cover 313.

For example, the book cover 311 may at least partially form a side portion of an outer surface of the electronic device 101. For example, the book cover 311 may at least partially form a rear portion of the outer surface. For example, the book cover 311 may include an opening 311a for one or more second image sensors 250-2. For example, the book cover 311 may include a surface supporting the plate 212. For example, the book cover 311 may be coupled to the plate 212. For example, the book cover 311 may include the frame cover 313. For example, the book cover 311 may be coupled to the frame cover 313.

For example, the plate 212 may at least partially form the rear portion of the outer surface. For example, the plate 212 may include an opening 212a for the one or more second image sensors 250-2. For example, the plate 212 may be disposed on the surface of the book cover 311. For example, the opening 212a may be aligned with the opening 311a.

For example, the frame cover 313 may be at least partially surrounded by the book cover 311.

For example, the frame cover 313 may be at least partially surrounded by the display 230. For example, the frame cover 313 may be at least partially surrounded by the display 230, but a position of the frame cover 313 may be maintained independently of movement of the display 230. For example, the frame cover 313 may be arranged in relation to at least a portion of components of the display 230. For example, the frame cover 313 may include rails 313a that provide (or guide) a moving path of at least one component of the display 230.

For example, the frame cover 313 may be coupled to at least one component of the electronic device 101. For example, the frame cover 313 may support a rechargeable battery 189. For example, the battery 189 may be supported through a recess or a hole in a surface 313b of the frame cover 313. For example, the frame cover 313 may be coupled to an end of a flexible printed circuit board (FPCB) 325 on the surface of the frame cover 313. For example, although not explicitly illustrated in FIG. 3A and FIG. 3B, another end of the FPCB 325 may be connected to a PCB 324 through at least one connector. For example, the PCB 324 may be electrically connected to another PCB (not illustrated in FIG. 3A and FIG. 3B) that supplies power to a motor 361 through the FPCB 325.

For example, the frame cover 313 may be coupled to at least one structure of the electronic device 101 for a plurality of states including the first state and the second state. For example, the frame cover 313 may fasten the motor 361 of the driving unit 360.

For example, the second housing 220 may include a front cover 321 and a slide cover 322.

For example, the front cover 321 may be at least partially surrounded by the display 230. For example, the front cover 321 may be coupled to at least a portion of a region 230a of the display 230 surrounding the front cover 321, unlike the frame cover 313, so that the display 230 moves along the second housing 220 that moves with respect to the first housing 210.

For example, the front cover 321 may be coupled to at least one component of the electronic device 101. For example, the front cover 321 may be coupled to the printed circuit board (PCB) 324 including the components of the electronic device 101. For example, the PCB 324 may include a processor 120 (not illustrated in FIG. 3A and FIG. 3B). For example, the front cover 321 may include the one or more second image sensors 250-2.

For example, the front cover 321 may be coupled to at least one structure of the electronic device 101 for the plurality of states including the first state and the second state. For example, the front cover 321 may fasten a rack gear 363 of the driving unit 360.

For example, the front cover 321 may be coupled to the slide cover 322.

For example, the slide cover 322 may be coupled to the front cover 321 to protect at least one component of the electronic device 101 coupled in the front cover 321 and/or at least one structure of the electronic device 101 coupled in the front cover 321. For example, the slide cover 322 may include the structure for the at least one component. For example, the slide cover 322 may include one or more openings 326 for the one or more second image sensors 250-2. For example, the one or more openings 326 may be aligned with the one or more second image sensors 250-2 disposed on the front cover 321. For example, a size of each of the one or more openings 326 may correspond to a size of each of the one or more second image sensors 250-2.

For example, the display 230 may include a support member 331. For example, the support member 331 may include a plurality of bars. For example, the plurality of bars may be coupled to each other.

For example, the driving unit 360 may include the motor 361, a pinion gear 362, and the rack gear 363.

For example, the motor 361 may operate based on power from the battery 189. For example, the power may be provided to the motor 361 in response to the predefined user input.

For example, the pinion gear 362 may be coupled to the motor 361 through a shaft. For example, the pinion gear 362 may be rotated based on the operation of the motor 361 transmitted through the shaft.

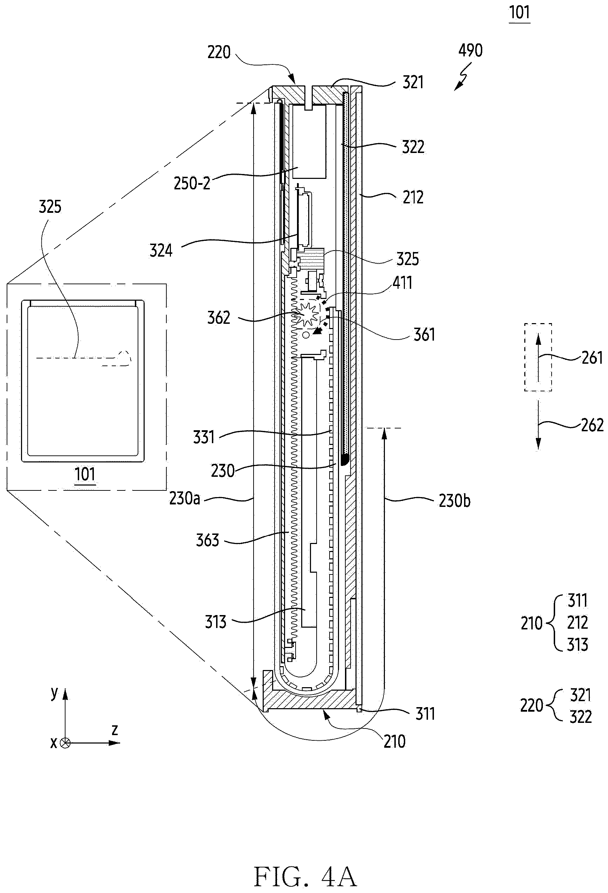

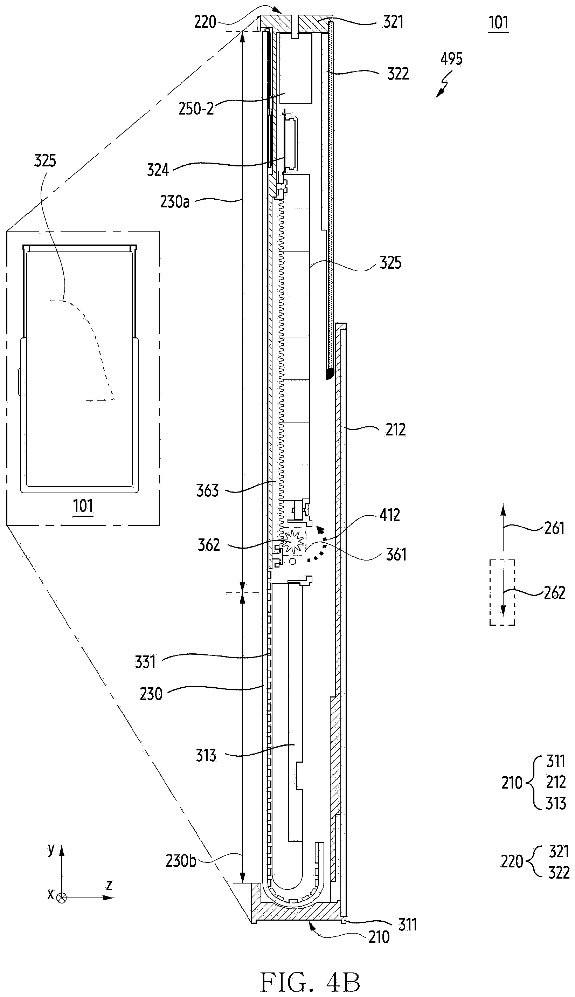

For example, the rack gear 363 may be arranged in relation to the pinion gear 362. For example, teeth of the rack gear 363 may be engaged with teeth of the pinion gear 362. For example, the rack gear 363 may be moved in a first direction 261 or a second direction 262 according to rotation of the pinion gear 362. For example, the second housing 220 may be moved in the first direction 261 and the second direction 262 by the rack gear 363 that is moved according to the rotation of the pinion gear 362 due to the operation of the motor 361. For example, the first state of the electronic device 101 may be changed to a state (e.g., the one or more intermediate states or the second state) different from the first state through the movement of the second housing 220 in the first direction 261. For example, the second state of the electronic device 101 may be changed to a state (e.g., the one or more intermediate states or the first state) different from the second state through the movement of the second housing 220 in the second direction 262. For example, it may be exemplified through FIG. 4A and FIG. 4B that the first state is changed to the second state by the driving unit 360 and that the second state is changed to the first state by the driving unit 360.

FIG. 4A is a cross-sectional view of an exemplary electronic device in a first state. FIG. 4B is a cross-sectional view of an exemplary electronic device in a second state.

Referring to FIG. 4A and FIG. 4B, a motor 361 may be operated based at least in portion on the predefined user input received in a state 490 which is the first state. For example, a pinion gear 362 may be rotated in a first rotation direction 411 based at least in portion on the operation of the motor 361. For example, a rack gear 363 may be moved in a first direction 261 based at least in portion on the rotation of the pinion gear 362 in the first rotation direction 411. For example, since a front cover 321 in a second housing 220 fastens the rack gear 363, the second housing 220 may be moved in the first direction 261 based at least in portion on the movement of the rack gear 363 in the first direction 261. For example, since the front cover 321 in the second housing 220 is coupled to at least a portion of a region 230a of a display 230 and fastens the rack gear 363, the display 230 may be moved based at least in portion on the movement of the rack gear 363 in the first direction 261. For example, the display 230 may be moved along rails 313a. For example, a shape of at least a portion of the plurality of bars of a support member 331 of the display 230 may change when the state 490 changes to a state 495 which is the second state.

For example, a region 230b of the display 230 may be moved according to the movement of the display 230. For example, when the state 490 changes to the state 495 according to the predefined user input, the region 230b may be moved through a space between a book cover 311 and a frame cover 313. For example, the region 230b in the state 495 may be exposed, unlike the region 230b rolled into the space in the state 490.

For example, since the front cover 321 in the second housing 220 is coupled to a PCB 324 connected to the other end of an FPCB 325 and fastens the rack gear 363, a shape of the FPCB 325 may be changed when the state 490 changes to the state 495.

The motor 361 may be operated based at least in portion on the predefined user input received in the state 495. For example, the pinion gear 362 may be rotated in a second rotation direction 412 based at least in portion on the operation of the motor 361. For example, the rack gear 363 may be moved in a second direction 262 based at least in portion on the rotation of the pinion gear 362 in the second rotation direction 412. For example, since the front cover 321 in the second housing 220 fastens the rack gear 363, the second housing 220 may be moved in the second direction 262 based at least in portion on the movement of the rack gear 363 in the second direction 262. For example, since the front cover 321 in the second housing 220 is coupled to at least the portion of the region 230a of the display 230 and fastens the rack gear 363, the display 230 may be moved based at least in portion on the movement of the rack gear 363 in the second direction 262. For example, the display 230 may be moved along the rails 313a. For example, the shape of at least the portion of the plurality of bars of the support member 331 of the display 230 may be changed when the state 495 changes to the state 490.

For example, the region 230b of the display 230 may be moved according to the movement of the display 230. For example, when the state 495 changes to the state 490 according to the predefined user input, the region 230b may be moved through the space between the book cover 311 and the frame cover 313. For example, the region 230b in the state 490 may be rolled into the space, unlike the region 230b exposed in the state 495.

For example, since the front cover 321 in the second housing 220 is coupled to the PCB 324 connected to the other end of the FPCB 325 and fastens the rack gear 363, the shape of the FPCB 325 may be changed when the state 495 changes to the state 490.

FIG. 2A to FIG. 4B illustrate the electronic devices 101 in which height of the display area is changed and width of the display area is maintained when the first state (or the second state) is changed to the second state (or the first state) in a portrait mode, but this is for convenience of description. For example, the electronic device 101 may be implemented such that the height of the display area is maintained and the width of the display area is changed when the first state (or the second state) changes to the second state (or the first state) in the portrait mode.

For example, when the motor 361 is driven to move the rack gear 363, a vibration may occur due to driving of the motor 361. By the motor 361, the vibration may be transmitted to the frame cover 313 or the front cover 321 supporting the motor 361. The frame cover 313 or the front cover 321 may generate noise by vibrating by the vibration transmitted from the motor 361. The noise generated by the motor 361 may cause inconvenience to a user. Hereinafter, a structure of the electronic device 101 including the structure for reducing the noise generated by the motor 361 will be described.

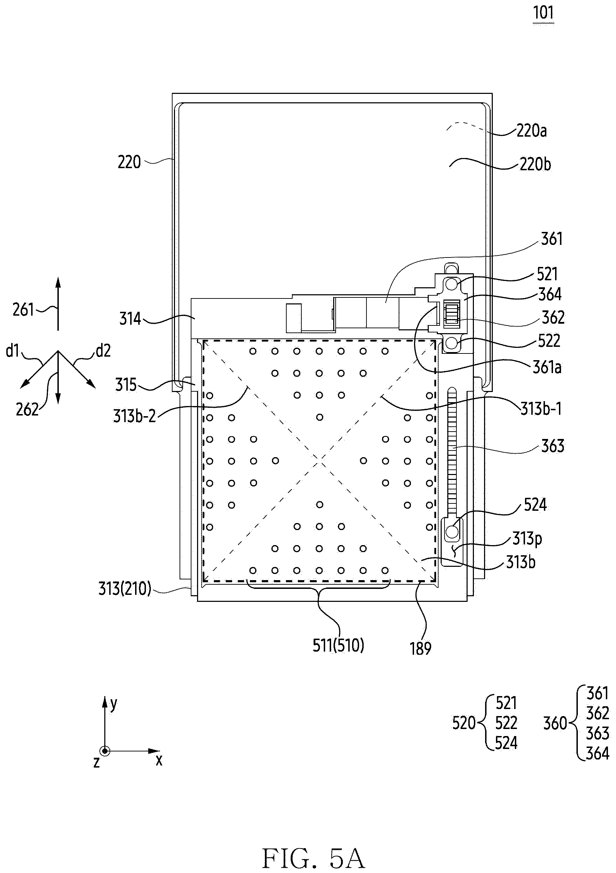

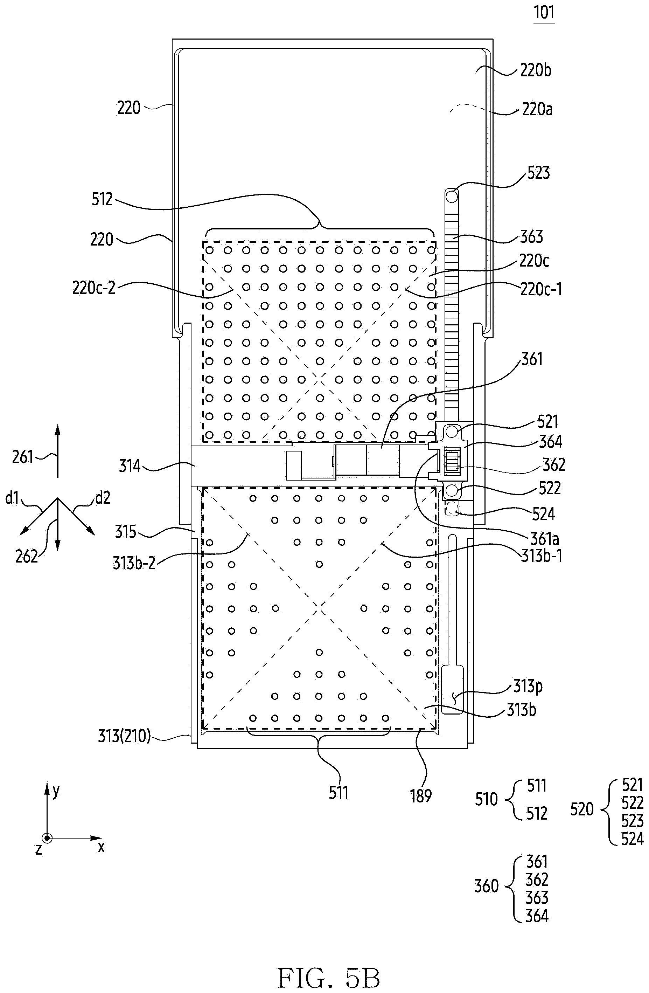

FIG. 5A is a top plan view of an exemplary electronic device in a first state, and FIG. 5B is a top plan view of an exemplary electronic device in a second state.

Referring to FIG. 5A and FIG. 5B, an electronic device 101 according to an embodiment may include a battery 189, a first housing 210, a second housing 220, a driving unit 360, a plurality of through holes 510, and/or a plurality of fastening members 520.

The first housing 210 may define at least a portion of an outer surface of the electronic device 101. According to an embodiment, the first housing 210 may provide a space in which various components in the electronic device 101 may be disposed together with the second housing 220. The first housing 210 may include a frame cover 313. The frame cover 313 may support the various components in the electronic device 101. For example, the frame cover 313 may support the battery 189 and/or a motor 361.

The second housing 220 may define at least a portion of the outer surface of the electronic device 101. According to an embodiment, the second housing 220 may be movable with respect to the first housing 210. For example, the second housing 220 may be slidable with respect to the first housing 210. According to an embodiment, the second housing 220 may slide into an inside of the first housing 210 or out to an outside of the first housing 210. For example, the second housing 220 may slide out to the outside of the first housing 210 as it moves in a first direction 261 (e.g., +y direction) with respect to the first housing. For another example, the second housing 220 may slide into the inside of the first housing 210 as it moves in a second direction (e.g., -y direction) with respect to the first housing 210. According to an embodiment, the second housing 220 may support the various components of the electronic device 101. For example, the second housing 220 may support a display (e.g., the display 230 of FIG. 2A, FIG. 2B, FIG. 2C, FIG. 2D, FIG. 3A, FIG. 3B, FIG. 4A, and FIG. 4B) disposed in a surface 220a of the second housing 220. For another example, the second housing 220 may support a PCB (e.g., the PCB 324 of FIG. 3A, FIG. 4A, and FIG. 4B) disposed in an inner surface 220b of the second housing 220 opposite to the surface 220a of the second housing 220.

According to an embodiment, the frame cover 313 may include a seating surface 313b. The battery 189 may be disposed on the seating surface 313b of the frame cover 313. A surface of the battery 189 may contact the seating surface 313b. The seating surface 313b may be spaced apart from the motor 361. For example, the seating surface 313b may be spaced apart from the motor 361 in a second direction 262. According to an embodiment, the seating surface 313b may be a surface extending with substantially constant thickness. For example, the seating surface 313b may extend along the first direction 261 or the second direction 262 with the substantially constant thickness.

According to an embodiment, the display 230 may slide into the inside the first housing 210 or out to the outside the first housing 210 by moving of the second housing 220. For example, as the second housing 220 moves in the first direction 261, the display 230 may slide out to the outside of the first housing 210. For example, as the second housing 220 moves in the second direction 262, the display 230 may slide into the inside of the first housing 210.

According to an embodiment, the driving unit 360 may move the second housing 220 with respect to the first housing 210. The driving unit 360 may include the motor 361, a pinion gear 362, and/or a rack gear 363. The motor 361 may provide a driving force for driving the second housing 220 based on power transmitted from the battery 189. According to an embodiment, the motor 361 may be disposed on the frame cover 313. The pinion gear 362 may be coupled to the motor 361 to be rotatable by the motor 361. For example, the pinion gear 362 may be rotatable by being coupled to a shaft of the motor 361. For example, the pinion gear 362 may be coupled to an end 361a of the motor 361. The rack gear 363 may be engaged with the pinion gear 362. The rack gear 363 may be coupled to the second housing 220. For example, the rack gear 363 may be disposed on the inner surface 220b of the second housing 220. For example, the rack gear 363 may be disposed at one periphery of the second housing 220 facing a direction (e.g., -x direction) perpendicular to a moving direction (e.g., +y direction or -y direction) of the second housing 220. The rack gear 363 may be movable by rotation of the pinion gear 362. For example, the rack gear 363 may move in the first direction 261 by the rotation of the pinion gear 362. As the rack gear 363 moves in the first direction 261, the second housing 220 coupled to the rack gear 363 may move in the first direction 261. For example, the rack gear 363 may move in the second direction 262 by the rotation of the pinion gear 362. As the rack gear 363 moves in the second direction 262, the second housing 220 coupled to the rack gear 363 may move in the second direction 262.

According to an embodiment, the frame cover 313 may include an operation space 313p. The operation space 313p may define at least a portion of a moving path of the rack gear 363. For example, the operation space 313p may be disposed at one periphery of the frame cover 313 facing the direction (e.g., -x direction) perpendicular to the moving direction of the second housing 220. The rack gear 363 may be movable to the first direction 261 or the second direction 262 within the operation space 313p by the rotation of the pinion gear 362.

The plurality of through holes 510 may reduce noise caused in the electronic device 101. According to an embodiment, the plurality of through holes 510 may penetrate a portion of components in the electronic device 101. For example, the plurality of through holes 510 may include a plurality of first through holes 511 disposed in the first housing 210 and a plurality of second through holes 512 disposed in the second housing 220.

The plurality of first through holes 511 may penetrate the portion of the frame cover 313. According to an embodiment, the plurality of first through holes 511 may penetrate the seating surface 313b of the frame cover 313. For example, the plurality of first through holes 511 may extend between the outer surface of the frame cover 313 facing the inner surface 220b of the second housing 220 and the seating surface 313b of the frame cover 313. According to an embodiment, the plurality of first through holes 511 may be spaced apart from each other on the seating surface 313b of the frame cover 313. For example, the seating surface 313b may include a first reinforcement portion 313b-1 and a second reinforcement portion 313b-2 spaced apart from the plurality of first through holes 511. The first reinforcement portion 313b-1 may extend in a fifth direction d1 tilted with respect to the moving direction of the second housing 220. For example, the fifth direction d1 may have slope with respect to the first direction 261 and/or the second direction 262. The second reinforcement portion 313b-2 may extend in a sixth direction d2 tilted with respect to the moving direction of the second housing 220. The sixth direction d2 may be distinguished from the fifth direction d1. The sixth direction d2 may cross the fifth direction d1. The second reinforcement portion 313b-2 may traverse the first reinforcement portion 313b-1. For example, the sixth direction d2 may be tilted with respect to the fifth direction d1 and the moving direction of the second housing 220. The sixth direction d2 may have slope with respect to the fifth direction d1 and the moving direction of the second housing 220. According to an embodiment, the plurality of first through holes 511 may not be formed in the first reinforcement portion 313b-1 and the second reinforcement portion 313b-2. As the plurality of first through holes 511 are not formed, the first reinforcement portion 313b-1 and the second reinforcement portion 313b-2 may secure rigidity of the frame cover 313.

According to an embodiment, the seating surface 313b on which the plurality of first through holes 511 are disposed may be a surface having the widest area among surfaces of the frame cover 313. For example, an area of the seating surface 313b may correspond to a surface of the battery 189 facing the seating surface 313b. For example, the area of the seating surface 313b may be greater than or equal to an area of the surface of the battery 189 facing the seating surface 313b. When the motor 361 is driven, a vibration generated from the motor 361 may be transmitted to the first housing 210 and the second housing 220. For example, the vibration transmitted from the motor 361 may be transmitted to the surfaces included in the frame cover 313 and vibrate the surfaces included in the frame cover 313. In case that the surfaces included in the frame cover 313 vibrate, magnitude of the noise generated from the surfaces included in the frame cover 313 may correspond to the area of each of the surfaces of the frame cover 313. For example, the noise generated from the surfaces included in the frame cover 313 may be generated by the vibration of the surfaces included in the frame cover 313 or vibration of air positioned on each of the surfaces included in the frame cover 313. In case that the surfaces included in the frame cover 313 vibrate, amplitude of each of the surfaces included in the frame cover 313 may correspond to the area of each of the surfaces of the frame cover 313. As the amplitude increases, the magnitude of the noise due to the vibration generated in the frame cover 313 increases, so relatively loud noise may be generated in the seating surface 313b of the frame cover 313 when the motor 361 is driven. The electronic device 101 according to an embodiment may provide a structure that reduces the noise generated by the motor 361 by the plurality of first through holes 511 disposed in the seating surface 313b. For example, as the plurality of first through holes 511 are formed in the seating surface 313b, the area of the seating surface 313b may be reduced compared to the case where the plurality of first through holes 511 are not formed. As the area of the seating surface 313b is reduced, the noise generated by the vibration transmitted from the motor 361 may be reduced. For example, as the plurality of first through holes 511 are formed in the seating surface 313b, the vibration of air positioned on the seating surface 313b may be reduced. As the vibration of air is reduced, the noise generated by the vibration transmitted from the motor 361 may be reduced.

According to an embodiment, the frame cover 313 may include a supporting portion 314 and a seating portion 315. The supporting portion 314 may mean a portion of the frame cover 313 supporting the motor 361. According to an embodiment, the supporting portion 314 may surround at least a portion of the motor 361. The seating portion 315 may mean another portion of the frame cover 313 supporting the battery 189. The seating portion 315 may be connected to the supporting portion 314. According to an embodiment, the seating portion 315 may define the seating surface 313b of the frame cover 313. The seating portion 315 may define the operation space 313p of the frame cover 313. According to an embodiment, the seating portion 315 may include material different from the supporting portion 314. For example, the seating portion 315 may include material having rigidity greater than that of the supporting portion 314. The supporting portion 314 may include material having flexibility greater than that of the seating portion 315. For example, the seating portion 315 may include stainless used steel (SUS). For example, the supporting portion 314 may include a resin. The supporting portion 314 may be manufactured by an injection process using a molten resin. According to an embodiment, as the material of the supporting portion 314 and the seating portion 315 are different from each other, the magnitude of the noise generated by the motor 361 may be reduced. For example, as the flexibility of the supporting portion 314 close to the motor 361 is greater than that of the seating portion 315, transmission of the vibration generated by the motor 361 to the seating portion315 may be reduced. The electronic device 101 according to an embodiment may provide the structure in which the magnitude of the noise generated by the motor 361 may be reduced as the transmission of the vibration to the seating portion 315 is reduced.

According to an embodiment, the plurality of second through holes 512 may penetrate the inner surface 220b of the second housing 220. For example, the plurality of second through holes 512 may extend from a surface 220a of the second housing 220 facing the display 230 to the inner surface 220b of the second housing 220. According to an embodiment, the plurality of second through holes 512 may penetrate at least the portion of the inner surface 220b of the second housing 220. The plurality of second through holes 512 may penetrate a cover region 220c overlapping at least a portion of the seating surface 313b among the inner surfaces 220b of the second housing 220 in the first state of the electronic device 101. According to an embodiment, the area of the cover region 220c overlapping the seating surface 313b of the frame cover 313 may be changed as the second housing 220 moves. For example, the area of the cover region 220c overlapping the seating surface 313b of the frame cover 313 may be reduced as the second housing 220 moves in the first direction 261. For example, the area of the cover region 220c overlapping the seating surface 313b of the frame cover 313 may increase as the second housing 220 moves in the second direction 262. According to an embodiment, the plurality of second through holes 512 may be spaced apart from each other on the cover region 220c of the second housing 220. For example, the cover region 220c may include a third reinforcement portion 220c-1 and a fourth reinforcement portion 220c-2 spaced apart from the plurality of second through holes 512. The third reinforcement portion 220c-1 may extend in the fifth direction d1 tilted with respect to the moving direction of the second housing 220. The fourth reinforcement portion 220c-2 may traverse the third reinforcement portion 220c-1. According to an embodiment, the plurality of second through holes 512 may not be formed in the third reinforcement portion 220c-1 and the fourth reinforcement portion 220c-2. As the plurality of second through holes 512 are not formed, the third reinforcement portion 220c-1 and the fourth reinforcement portion 220c-2 may secure the rigidity of the second housing 220.

According to an embodiment, the cover region 220c in which the plurality of second through holes 512 are disposed may be a region having the widest area among regions included in the inner surface 220b of the second housing 220. For example, the area of the cover region 220c may correspond to the area of the seating surface 313b of the frame cover 313. When the motor 361 is driven, the vibration generated by the motor 361 may be transmitted to the rack gear 363 engaged with the pinion gear 362 through the pinion gear 362. The vibration transmitted to the rack gear 363 may be transmitted to the second housing 220, and vibrate the second housing 220. The vibration of the second housing 220 may generate noise. The electronic device 101 according to an embodiment may provide the structure for reducing the noise generated by the motor 361 by the plurality of second through holes 512 disposed in the cover region 220c of the second housing 220. For example, as the plurality of second through holes 512 are formed in the cover region 220c, the area of the cover region 220c may be reduced compared to the case where the plurality of second through holes 512 are not formed. As the area of the cover region 220c is reduced, the noise generated by the vibration transmitted from the motor 361 may be reduced.

According to an embodiment, at least a portion of the plurality of second through holes 512 may overlap at least a portion of the plurality of first through holes 511 disposed in the seating surface 313b. As the second housing 220 moves, the number of the plurality of second through holes 512 overlapping the plurality of first through holes 511 may be changed. For example, as the second housing 220 moves in the first direction 261, the number of the plurality of second through holes 512 overlapping the plurality of first through holes 511 may decrease. For example, as the second housing 220 moves in the second direction 262, the number of the plurality of second through holes 512 overlapping the plurality of first through holes 511 may increase. For example, the number of the plurality of second through holes 512 overlapping the plurality of first through holes 511 in the first state of electronic device 101 may be greater than the number of second through holes 512 overlapping the plurality of first through holes 511 in the second state of electronic device 101.

According to an embodiment, the driving unit 360 may include a motor bracket 364. The motor bracket 364 may maintain coupling between the motor 361 and the frame cover 313. According to an embodiment, the motor bracket 364 may surround a portion of the motor 361. The motor bracket 364 may surround the pinion gear 362 disposed at an end 361a of the motor 361. For example, the motor bracket 364 may be disposed on the supporting portion 314 of the frame cover 313. For example, the motor bracket 364 may include the resin. The motor bracket 364 may be manufactured by the injection process using the molten resin, but is not limited thereto.

The plurality of fastening members 520 may couple components of the driving unit 360 to the first housing 210 and/or the second housing 220. For example, the plurality of fastening members 520 may be a screw, but is not limited thereto. According to an embodiment, the plurality of fastening members 520 may include a first fastening member 521, a second fastening member 522, a third fastening member 523, and/or a fourth fastening member 524.

The first fastening member 521 and the second fastening member 522 may fasten the motor 361 to the frame cover 313. According to an embodiment, the first fastening member 521 may penetrate a portion of the motor bracket 364. The first fastening member 521 may couple the motor 361 to the frame cover 313. For example, the first fastening member 521 may penetrate the portion of the motor bracket 364 and the supporting portion 314. According to an embodiment, the second fastening member 522 may penetrate another portion of the motor bracket 364. The second fastening member 522 may couple the motor 361 to the frame cover 313. For example, the second fastening member 522 may penetrate another portion of the motor bracket 364 and the supporting portion 314. According to an embodiment, the second fastening member 522 may be spaced apart from the first fastening member 521. For example, the second fastening member 522 and the first fastening member 521 may be disposed on the moving path of the rack gear 363. The first fastening member 521 and the second fastening member 522 may be disposed on an imaginary straight line extending in a direction (e.g., +y direction or -y direction) parallel to the moving path of the rack gear 363. In case that the first fastening member 521 and the second fastening member 522 are not disposed on the straight line, when the rack gear 363 moves based on the driving of the motor 361, the rack gear 363 may be tilted with respect to the first direction 261 and/or the second direction 262 which are moving directions of the rack gear 363. As the rack gear 363 is tilted, the second housing 220 may be tilted with respect to the first direction 261 and/or the second direction 262. When the second housing 220 is tilted, friction between the second housing 220 and the frame cover 313 may occur, and noise may be generated. The electronic device 101 according to an embodiment may provide a structure capable of stably supporting the rack gear 363 by the first fastening member 521 and the second fastening member 522 disposed on the straight line. As the rack gear 363 is stably supported by the first fastening member 521 and the second fastening g member 522, the noise generated when the motor 361 is driven may be reduced.

The third fastening member 523 and the fourth fastening member 524 may fasten the rack gear 363 to the second housing 220. According to an embodiment, the third fastening member 523 may penetrate an end of the rack gear 363. The third fastening member 523 may couple the rack gear 363 to the second housing 220. For example, the third fastening member 523 may penetrate an end of the rack gear 363 and the second housing 220. According to an embodiment, the fourth fastening member 524 may penetrate another end of the rack gear 363. The fourth fastening member 524 may couple the rack gear 363 to the second housing 220. For example, the fourth fastening member 524 may penetrate another end of the rack gear 363 and the second housing 220. According to an embodiment, the fourth fastening member 524 may be spaced apart from the third fastening member 523. For example, the first fastening member 521, the second fastening member 522, the third fastening member 523, and the fourth fastening member 524 may be disposed on the moving path of the rack gear 363. For example, the first fastening member 521, the second fastening member 522, the third fastening member 523, and the fourth fastening member 524 may be disposed on the imaginary straight line extending in the direction (e.g., +y direction or -y direction) parallel to the moving path of the rack gear 363. The electronic device 101 according to an embodiment may provide the structure that reduces the noise generated when the motor 361 is driven by the third fastening member 523 and the fourth fastening member 524 disposed on the straight line.

As described above, the electronic device 101 according to an embodiment may provide the structure capable of reducing the noise generated by the motor 361 by the plurality of first through holes 511 disposed in the seating surface 313b. The electronic device 101 according to an embodiment may provide the structure capable of reducing the noise generated by the motor 361 by the plurality of second through holes 512 disposed in the cover region 220c. Since the material of the supporting portion 314 supporting the motor 361 is different from another portion of the frame cover 313, the electronic device 101 according to an embodiment may provide the structure capable of reducing the noise generated by the motor 361. The electronic device 101 according to an embodiment may provide the structure capable of reducing the noise generated by the motor 361 by the plurality of fastening members 520 disposed on the straight line.

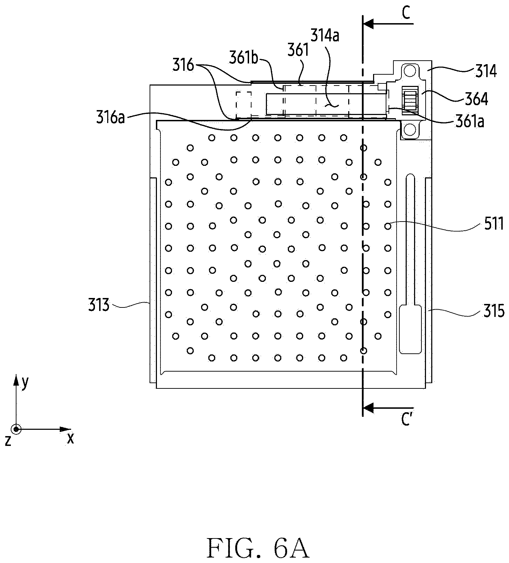

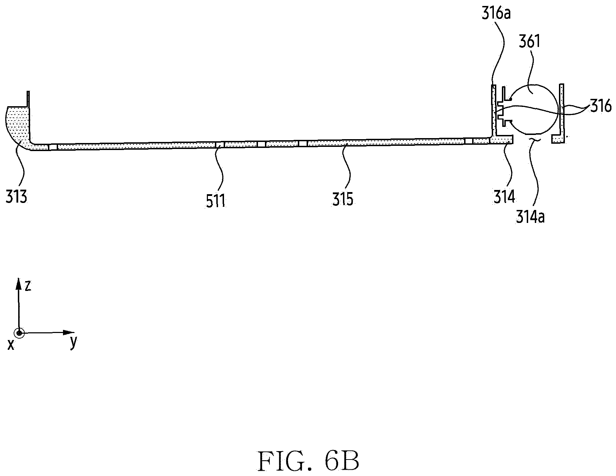

FIG. 6A is a top plan view of a frame cover of an exemplary electronic device, and FIG. 6B is a cross-sectional view illustrating an example of a frame cover of an exemplary electronic device cut along line C-C' of FIG. 6A.

Since a frame cover 313 of FIG. 6A and FIG. 6B may be the frame cover 313 in which a portion of the structure of the frame cover 313 of FIG. 5A and FIG. 5B is changed, a repeated description will be omitted.

Referring to FIG. 6A and FIG. 6B, according to an embodiment, each of a plurality of first through holes 511 may be spaced apart at a preset interval on a seating surface 313b. For example, the interval between each of the plurality of first through holes 511 may be constant.

According to an embodiment, the frame cover 313 may include partition walls 316 surrounding a motor 361. The motor 361 may be disposed between the partition walls 316. Among the partition walls 316, a portion 316a close to a seating portion 315 may divide a supporting portion 314 and the seating portion 315.

According to an embodiment, the frame cover 313 may include an extension hole 314a corresponding to the motor 361. The extension hole 314a may be disposed on the supporting portion 314 of the frame cover 313. The extension hole 314a may penetrate a surface of the supporting portion 314 facing the motor 361. For example, the extension hole 314a may extend between an end 361a of the motor 361 and another end 361b of the motor 361 opposite to the end 361a of the motor 361. For example, length of the extension hole 314a may correspond to length of the motor 361. The length of the extension hole 314a may mean the length in a direction parallel to a direction (e.g., -x direction) from the end 361a of the motor 361 toward another end 361b of the motor 361.

According to an embodiment, the motor 361 may be disposed on the extension hole 314a. The motor 361 may be spaced apart from the frame cover 313 as it is disposed on the extension hole 314a. For example, the motor 361 may be coupled to the frame cover 313 through a motor bracket 364 and may not directly contact the frame cover 313. As the motor 361 and the frame cover 313 are spaced apart from each other, when the motor 361 is driven, transmission of vibration generated from the motor 361 to the frame cover 313 may be reduced.

As described above, the electronic device (e.g., the electronic device 101 of FIG. 5A and FIG. 5B) according to an embodiment may provide a structure capable of reducing noise generated from the motor 361 by the motor 361 disposed on the extension hole 314a.

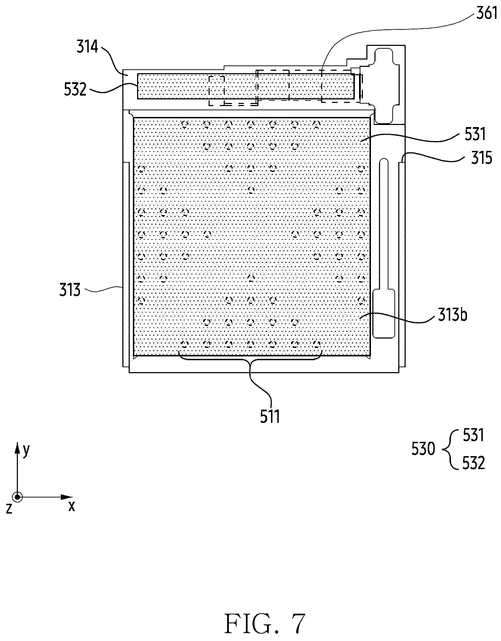

FIG. 7 is a top plan view of a first housing of an exemplary electronic device.

A frame cover 313 of FIG. 7 may be the frame cover 313 to which a plurality of sound absorbers 530 are added from the frame cover 313 of FIG. 5A and FIG. 5B, and a repeated description will be omitted.

Referring to FIG. 7, an electronic device (e.g., the electronic device 101 of FIG. 5A and FIG. 5B) according to an embodiment may include the plurality of sound absorbers 530. The plurality of sound absorbers 530 may absorb vibration or noise generated from a motor 361. For example, the plurality of sound absorbers 530 may include rubber, a sponge, or a polymer. According to an embodiment, the plurality of sound absorbers 530 may include a first sound absorber 531 and a second sound absorber 532.

According to an embodiment, the first sound absorber 531 may be disposed on a seating portion 315 of a frame cover 313. For example, the first sound absorber 531 may be disposed on a seating surface 313b of the frame cover 313. According to an embodiment, the first sound absorber 531 may cover at least a portion of a plurality of first through holes 511. For example, an area of the first sound absorber 531 may correspond to the seating surface 313b, but is not limited thereto. The first sound absorber 531 may contact the seating surface 313b. As the first sound absorber 531 contacts the seating surface 313b, generation of the noise in the seating surface 313b may be reduced.

According to an embodiment, the second sound absorber 532 may be disposed on a supporting portion 314 of the frame cover 313. For example, the second sound absorber 532 may be disposed on a surface of the supporting portion 314 facing the motor 361. For example, an area of the second sound absorber 532 may correspond to the area of the surface of the supporting portion 314, but is not limited thereto. The second sound absorber 532 may contact the supporting portion 314. As the second sound absorber 532 contacts the supporting portion 314, generation of the noise in the supporting portion 314 may be reduced.

As described above, the electronic device 101 according to an embodiment may provide a structure that reduces the noise generated by the motor 361 through the plurality of sound absorbers 530 disposed on the frame cover 313.

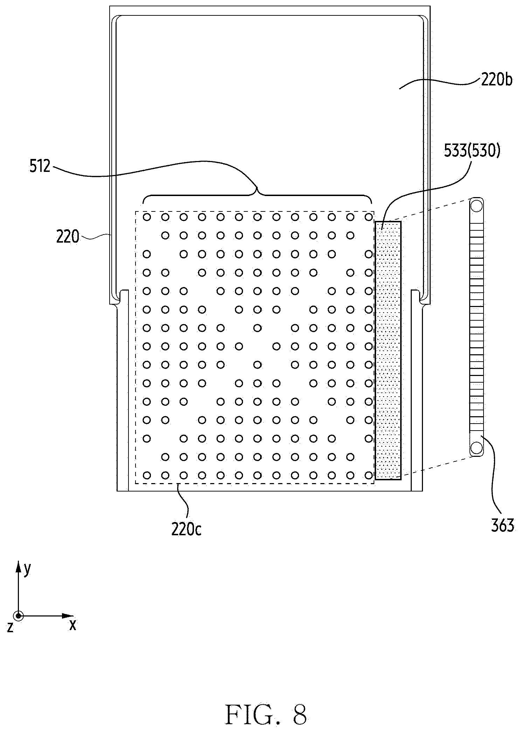

FIG. 8 is a top plan view of a second housing of an exemplary electronic device.

A second housing 220 of FIG. 8 may be the second housing 220 to which a plurality of sound absorbers 530 are added from the second housing 220 of FIG. 5A and FIG. 5B, and a repeated description will be omitted.

Referring to FIG. 8, according to an embodiment, the plurality of sound absorbers 530 may include a third sound absorber 533. The third sound absorber 533 may be disposed on the second housing 220. For example, the third sound absorber 533 may be disposed on an inner surface 220b of the second housing 220. The third sound absorber 533 may face a surface of a rack gear 363 facing the inner surface 220b of the second housing 220. According to an embodiment, the third sound absorber 533 may extend in a moving direction (e.g., -y direction or +y direction) of the rack gear 363. For example, length of the third sound absorber 533 may correspond to the length of the rack gear 363. The third sound absorber 533 may contact the rack gear 363. The third sound absorber 533 contacting the rack gear 363 may absorb vibration and/or the noise transmitted from a motor (e.g., the motor 361 of FIG. 5A and FIG. 5B) to the rack gear 363.

According to an embodiment, the third sound absorber 533 may be disposed outside a cover region 220c. For example, the third sound absorber 533 may be spaced apart from a plurality of second through holes 512 disposed in the cover region 220c. However, it is not limited thereto, and according to an embodiment, the third sound absorber 533 may be disposed on the cover region 220c. In case that the third sound absorber 533 is disposed on the cover region 220c, the third sound absorber 533 may cover the plurality of second through holes 512.

As described above, the electronic device 101 according to an embodiment may provide a structure that reduces noise generated by the motor 361 through the plurality of sound absorbers 530 disposed on the second housing 220.

The electronic device capable of changing a size of a display area of a display visible from the outside may include a plurality of housings movable with respect to each other. The electronic device may include a motor that provides a driving force for moving the plurality of housings. When the motor is driven, the vibration generated by the motor may generate the noise. The electronic device may need the structure for reducing the noise generated in the electronic device.

An electronic device (e.g., the electronic device 101 of FIG. 5A and FIG. 5B) according to an embodiment may include a first housing (e.g., the first housing 210 of FIG. 5A and FIG. 5B) including a frame cover (e.g., the frame cover 313 of FIG. 5A and FIG. 5B). The electronic device according to an embodiment may include a second housing (e.g., the second housing 220 of FIG. 5A and FIG. 5B) slidably coupled to the first housing. The electronic device according to an embodiment may include a flexible display (e.g., the display 230 of FIG. 4A and FIG. 4B), disposed on a surface (e.g., the surface 220a of FIG. 5A and FIG. 5B) of the second housing, sliding into an inside of the first housing or out to an outside of the first housing by moving of the second housing. The electronic device according to an embodiment may include a motor (e.g., the motor 361 of FIG. 5A and FIG. 5B) disposed on the frame cover. The electronic device according to an embodiment may include a pinion gear (e.g., the pinion gear 362 of FIG. 5A and FIG. 5B) coupled to the motor to be rotatable by the motor. The electronic device according to an embodiment may include a rack gear (e.g., the rack gear 363 of FIG. 5A and FIG. 5B), disposed on an inner surface (e.g., the inner surface 220b of FIG. 5A and FIG. 5B) of the second housing opposite to the surface of the second housing, engaged with the pinion gear to be movable according to rotation of the pinion gear. The electronic device according to an embodiment may include a battery (e.g., the battery 189 of FIG. 5A and FIG. 5B), disposed on a seating surface (e.g., the seating surface 313b of FIG. 5A and FIG. 5B) of the frame cover spaced apart from the motor, configured to supply power to the motor. The frame cover according to an embodiment may include a plurality of first through holes (e.g., the plurality of first through holes 511 of FIG. 5A and FIG. 5B) penetrating the seating surface contacting the battery.

An electronic device according to an embodiment may provide a structure capable of reducing noise generated by a motor by a plurality of first through holes disposed on a seating surface.

The seating surface according to an embodiment may include a first reinforcement portion (e.g., the first reinforcement portion 313b-1 of FIG. 5A and FIG. 5B), extending in a first direction (e.g., the fifth direction d1 of FIG. 5A and FIG. 5B) tilted with respect to a moving direction of the second housing, spaced apart from the plurality of first through holes. The seating surface according to an embodiment may include a second reinforcement portion (e.g., the second reinforcement portion 313b-2 of FIG. 5A and FIG. 5B), across the first reinforcement portion, extending in a second direction (e.g., the sixth direction d6 of FIG. 5A and FIG. 5B), tilted with respect to the moving direction of the second housing and distinct from the first direction, spaced apart from the plurality of first through holes. The plurality of first through holes according to an embodiment may be disposed between the first reinforcement portion and the second reinforcement portion.

An electronic device according to an embodiment may provide a structure capable of securing rigidity of a frame cover by a first reinforcement portion a second reinforcement portion.

An area of the seating surface according to an embodiment may correspond to an area of a surface of the battery facing the seating surface.

An electronic device according to an embodiment may provide a structure capable of reducing noise generated by a motor since a plurality of first through holes are formed in a seating surface having a size corresponding to a surface of a battery.

The electronic device according to an embodiment may include a first sound absorber (e.g., the first sound absorber 531 of FIG. 7) disposed on the seating surface.

An electronic device according to an embodiment may provide a structure capable of reducing noise generated by a motor through a first sound absorber.

The flexible display according to an embodiment may include a display area exposed to an outside of the electronic device. The display area according to an embodiment may have a first size in a first state in which the flexible display is slid into the inside of the first housing, and a second size greater than the first size in a second state in which the flexible display is slid out to the outside of the first housing. The second housing according to an embodiment may include a cover region (e.g., the cover region 220c of FIG. 5A and FIG. 5B) overlapping at least a portion of the seating surface among the inner surface of the second housing in the first state of the flexible display. The second housing according to an embodiment may include a plurality of second through holes (e.g., the plurality of second through holes 512 of FIG. 5A and FIG. 5B) penetrating the cover region.

An electronic device according to an embodiment may provide a structure capable of reducing noise generated by a motor by a plurality of second through holes disposed in a cover region.

An area of the cover region according to an embodiment may correspond to an area of the seating surface.

An electronic device according to an embodiment may provide a structure capable of reducing noise generated by a motor by a plurality of second through holes formed in a cover region having an area corresponding to an area of a seating surface.

The cover region according to an embodiment may include a third reinforcement portion (e.g., the third reinforcement portion 220c-1 of FIG. 5A and FIG. 5B), extending in a first direction (e.g., the fifth direction d1 of FIG. 5A and FIG. 5B) tilted with respect to a moving direction of the second housing, spaced apart from the plurality of second through holes. The cover region according to an embodiment may include a fourth reinforcement portion (e.g., the fourth reinforcement portion 220c-2 of FIG. 5A and FIG. 5B), across the third reinforcement portion, extending in a second direction (e.g., the sixth direction d2 of FIG. 5A and FIG. 5B) tilted with respect to the moving direction of the second housing and distinct from the first direction, spaced apart from the plurality of second through holes. The plurality of second through holes according to an embodiment may be disposed between the third reinforcement portion and the fourth reinforcement portion.

An electronic device according to an embodiment may provide a structure capable of securing rigidity of a second housing by a third reinforcement portion and a fourth reinforcement portion.

The frame cover according to an embodiment may include a supporting portion (e.g., the supporting portion 314 of FIG. 5A and FIG. 5B) facing the motor. The frame cover according to an embodiment may include a seating portion (e.g., the seating portion 315 of FIG. 5A and FIG. 5B), including material different from the supporting portion, and supporting the battery.

An electronic device according to an embodiment may provide a structure capable of reducing noise generated by a motor by a frame cover made of different material.

The supporting portion according to an embodiment may include an extension hole (e.g., the extension hole 314a of FIG. 6A and FIG. 6B), extending between an end of the motor facing the pinion gear and another end of the motor, penetrating a surface of the supporting portion facing the motor. The motor according to an embodiment may be spaced apart from the surface of the supporting portion on the extension hole.

An electronic device according to an embodiment may provide a structure capable of reducing noise generated by a motor since the motor is spaced apart from a frame cover by an extension hole.

The electronic device according to an embodiment may include a second sound absorber (e.g., the second sound absorber 532 of FIG. 7) disposed on a surface of the supporting portion facing the motor.

An electronic device according to an embodiment may provide a structure capable of reducing noise generated by a motor through a second sound absorber.

The electronic device according to an embodiment may include a third sound absorber (e.g., the third sound absorber 533 of FIG. 8), disposed on the inner surface of the second housing, and facing a surface of the rack gear.

An electronic device according to an embodiment may provide a structure capable of reducing noise generated by a motor through a third sound absorber.

The frame cover according to an embodiment may include a motor bracket (e.g., the motor bracket 364 of FIG. 5A and FIG. 5B), covering the pinion gear and a portion of the motor. The frame cover according to an embodiment may include a first fastening member (e.g., the first fastening member 521 of FIG. 5A and FIG. 5B), penetrating a portion of the motor bracket, coupling the motor to the frame cover. The frame cover according to an embodiment may further include a second fastening member (e.g., the second fastening member 522 of FIG. 5A and FIG. 5B), penetrating another portion of the motor bracket, coupling the motor to the frame cover. According to an embodiment, the first and second fastening members may be disposed on a moving path of the rack gear.

An electronic device according to an embodiment may provide a structure capable of reducing noise generated by a motor by a plurality of fastening members disposed on a moving path of a rack gear.

The second housing according to an embodiment may include a third fastening member (e.g., the third fastening member 523 of FIG. 5A and FIG. 5B), penetrating an end of the rack gear, coupling the rack gear to the second housing. The second housing according to an embodiment may include a fourth fastening member (e.g., the fourth fastening member 524 of FIG. 5A and FIG. 5B), penetrating another end of the rack gear, coupling the rack gear to the second housing. According to an embodiment, the first, second, third, and fourth fastening members may be disposed on a straight line.

An electronic device according to an embodiment may provide a structure capable of reducing noise generated by a motor by a plurality of fastening members disposed on a straight line.

The frame cover according to an embodiment may include an operation space (e.g., the operation space 313p of FIG. 5A and FIG. 5B) accommodating the rack gear. The rack gear according to an embodiment may be movable within the operation space by rotation of the pinion gear.

An electronic device according to an embodiment may provide a structure in which a rack gear is movable by an operating space formed in a frame cover.

The rack gear according to an embodiment may be disposed on a periphery of the second housing facing a direction perpendicular to a moving direction of the second housing.

According to an embodiment, an electronic device may provide a structure capable of reducing waste of a space in the electronic device by a rack gear disposed at a periphery of a second housing.

An electronic device (e.g., the electronic device 101 of FIG. 5A and FIG. 5B) according to an embodiment may include a first housing (e.g., the first housing 210 of FIG. 5A and FIG. 5B) including a frame cover (e.g., the frame cover 313 of FIG. 5A and FIG. 5B). The electronic device according to an embodiment may include a second housing (e.g., the second housing 220 of FIG. 5A and FIG. 5B) slidably coupled to the first housing. The electronic device according to an embodiment may include a flexible display (e.g., the display 230 of FIG. 4A and FIG. 4B), including a display area disposed on a surface (e.g., the surface 220a of FIG. 5A and FIG. 5B) of the second housing and exposed to an outside of the electronic device, changeable to a first state in which the display area has a first size or to a second state in which the display area has a second size greater than the first size by moving of the second housing. The electronic device according to an embodiment may include a motor (e.g., the motor 361 of FIG. 3B) disposed on the frame cover. The electronic device according to an embodiment may include a pinion gear (e.g., the pinion gear 362 of FIG. 5A and FIG. 5B) coupled to the motor to be rotatable by the motor. The electronic device according to an embodiment may include a rack gear (e.g., the rack gear 363 of FIG. 5A and FIG. 5B), disposed on an inner surface (e.g., the inner surface 220b of FIG. 5A and FIG. 5B) of the second housing opposite to the surface of the second housing, engaged with the pinion gear to be rotatable according to rotation of the pinion gear. The electronic device according to an embodiment may include a battery (e.g., the battery 189 of FIG. 5A and FIG. 5B), disposed on a seating surface (e.g., the seating surface 313b of FIG. 5A and FIG. 5B) of the frame cover spaced apart from the motor, and configured to supply power to the motor. The frame cover according to an embodiment may include a plurality of first through holes (e.g., the plurality of first through holes 511 of FIG. 5A and FIG. 5B) penetrating the seating surface contacting the battery. The second housing according to an embodiment may include a cover region (e.g., the cover region 220c of FIG. 5A and FIG. 5B) overlapping at least a portion of the seating surface in the first state, and a plurality of second through holes (e.g., the plurality of second through holes 512 of FIG. 5A and FIG. 5B) penetrating the cover region.

An electronic device according to an embodiment may provide a structure capable of reducing noise generated by a motor by a plurality of first through holes and a plurality of second through holes.

An area of the seating surface according to an embodiment may correspond to an area of a surface of the battery facing the seating surface.

An electronic device according to an embodiment may provide a structure capable of reducing noise generated by a motor since a plurality of first through holes are formed in a seating surface having a size corresponding to a surface of a battery.

The frame cover according to an embodiment may include a supporting portion (e.g., the supporting portion 314 of FIG. 5A and FIG. 5B) facing the motor. The frame cover according to an embodiment may include a seating portion (e.g., the seating portion 315 of FIG. 5A and FIG. 5B), including material different from the supporting portion, and supporting the battery.

An electronic device according to an embodiment may provide a structure capable of reducing noise generated by a motor by a frame cover made of different material.

The frame cover according to an embodiment may include a motor bracket (e.g., the motor bracket 364 of FIG. 5A and FIG. 5B), covering the pinion gear and a portion of the motor. The frame cover according to an embodiment may include a first fastening member (e.g., the first fastening member 521 of FIG. 5A and FIG. 5B), penetrating a portion of the motor bracket, coupling the motor to the frame cover. The frame cover according to an embodiment may further include a second fastening member (e.g., the second fastening member 522 of FIG. 5A and FIG. 5B), penetrating another portion of the motor bracket, coupling the motor to the frame cover. According to an embodiment, the first and second fastening members may be disposed on a moving path of the rack gear.

An electronic device according to an embodiment may provide a structure capable of reducing noise generated by a motor by a plurality of fastening members disposed on a moving path of a rack gear.

An area of the cover region according to an embodiment may correspond to an area of the seating surface.

An electronic device according to an embodiment may provide a structure capable of reducing noise generated by a motor by a plurality of second through holes formed in a cover region having an area corresponding to an area of a seating surface.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first housing including a frame cover;
a second housing slidably coupled to the first housing;
a flexible display, disposed on a surface of the second housing, sliding into an inside of the first housing or out to an outside of the first housing by moving of the second housing;
a motor disposed on the frame cover;
a pinion gear coupled to the motor to be rotatable by the motor;
a rack gear, disposed on an inner surface of the second housing opposite to the surface of the second housing, engaged with the pinion gear to be movable according to rotation of the pinion gear; and
a battery, disposed on a seating surface of the frame cover spaced apart from the motor, configured to supply power to the motor,
wherein the frame cover includes a plurality of first through holes penetrating the seating surface contacting the battery.

2. The electronic device of claim 1,
wherein the seating surface includes:
a first reinforcement portion, extending in a first direction tilted with respect to a moving direction of the second housing, spaced apart from the plurality of first through holes; and
a second reinforcement portion, across the first reinforcement portion, extending in a second direction tilted with respect to the moving direction of the second housing and distinct from the first direction, spaced apart from the plurality of first through holes, wherein the plurality of first through holes are disposed between the first reinforcement portion and the second reinforcement portion.

3. The electronic device of any one of claims 1 and 2,
wherein an area of the seating surface corresponds to an area of a surface of the battery facing the seating surface.

4. The electronic device of any one of claims 1 to 3 further comprising:
a first sound absorber disposed on the seating surface.

5. The electronic device of any one of claims 1 to 4,
wherein the flexible display includes a display area exposed to an outside of the electronic device,
wherein the display area is having:
a first size in a first state in which the flexible display is slid into the inside of the first housing; and
a second size greater than the first size in a second state in which the flexible display is slid out to the outside of the first housing,
wherein the second housing includes:
a cover region overlapping at least a portion of the seating surface among the inner surface of the second housing in the first state of the flexible display; and
a plurality of second through holes penetrating the cover region.

6. The electronic device of any one of claims 1 to 5,
wherein an area of the cover region corresponds to an area of the seating surface.

7. The electronic device of any one of claims 1 to 6,
wherein the cover region includes:
a third reinforcement portion, extending in a first direction tilted with respect to a moving direction of the second housing, spaced apart from the plurality of second through holes; and
a fourth reinforcement portion, across the third reinforcement portion, extending in a second direction tilted with respect to the moving direction of the second housing and distinct from the first direction, spaced apart from the plurality of second through holes,
wherein the plurality of second through holes are disposed between the third reinforcement portion and the fourth reinforcement portion.

8. The electronic device of any one of claims 1 to 7,
wherein the frame cover further includes:
a supporting portion facing the motor; and
a seating portion, comprising material different from the supporting portion, supporting the battery.

9. The electronic device of any one of claims 1 to 8,
wherein the supporting portion includes:
an extension hole, extending between an end of the motor facing the pinion gear and another end of the motor, penetrating a surface of the supporting portion facing the motor,
wherein the motor is spaced apart from the surface of the supporting portion on the extension hole.

10. The electronic device of any one of claims 1 to 9 further comprising:
a second sound absorber disposed on a surface of the supporting portion facing the motor.

11. The electronic device of any one of claims 1 to 10 comprising:
a third sound absorber, disposed on the inner surface of the second housing, facing a surface of the rack gear.

12. The electronic device of any one of claims 1 to 11,
wherein the frame cover further includes:
a motor bracket, covering the pinion gear and a portion of the motor;
a first fastening member, penetrating a portion of the motor bracket, coupling the motor to the frame cover; and
a second fastening member, penetrating another portion of the motor bracket, coupling the motor to the frame cover,
wherein the first and second fastening members are disposed on a moving path of the rack gear.

13. The electronic device of any one of claims 1 to 12,
wherein the second housing includes:
a third fastening member, penetrating an end of the rack gear, coupling the rack gear to the second housing; and
a fourth fastening member, penetrating another end of the rack gear, coupling the rack gear to the second housing,
wherein the first, second, third, and fourth fastening members are disposed on a straight line.

14. The electronic device of any one of claims 1 to 13,
wherein the frame cover further includes an operation space accommodating the rack gear,
wherein the rack gear is movable within the operation space by rotation of the pinion gear.

15. The electronic device of any one of claims 1 to 14,
wherein the rack gear is disposed on a periphery of the second housing facing a direction perpendicular to a moving direction of the second housing.
